Europäisches Patentamt

European Patent Office

Office européen des brevets

(19)

(11) Numéro de publication: **0 044 237**
**B1**

(12) **FASCICULE DE BREVET EUROPEEN**

(45) Date de publication du fascicule du brevet:
**10.01.90**

(51) Int. Cl.⁴: **H 03 J 3/28, H 03 J 5/02**

(21) Numéro de dépôt: **81401007.0**

(22) Date de dépôt: **23.06.81**

(54) **Dispositif de réglage du point de fonctionnement d'un circuit électronique à plusieurs éléments variables, notamment pour récepteur de télévision.**

(30) Priorité: **04.07.80 FR 8014908**

(43) Date de publication de la demande:
**20.01.82 Bulletin 82/3**

(45) Mention de la délivrance du brevet:
**10.01.90 Bulletin 90/2**

(84) Etats contractants désignés:
**BE DE GB IT NL SE**

(56) Documents cités:
**DE-A- 2 834 231**
**DE-A- 28 145 77**
**FR-A- 2 388 440**
**US-A- 4 121 162**
**US-A- 41 444 98**
**US-A- 41 526 54**
**US-A- 41 616 99**

(73) Titulaire: **THOMSON-BRANDT, 173, Boulevard Haussmann, F-75379 Paris Cedex 08 (FR)**

(72) Inventeur: **Shepherd, John, THOMSON-CSF CSPI- 173, bld Haussmann, F-75360 Paris Cedex 08 (FR)**
Inventeur: **Magnan de Bornier, Fabrice, THOMSON-CSF CSPI- 173, bld Haussmann, F-75360 Paris Cedex 08 (FR)**

(74) Mandataire: **Grynwald, Albert et al, THOMSON-CSF SCPI, F-92045 PARIS LA DEFENSE CEDEX 67 (FR)**

ACTORUM AG

## Description

La présente invention concerne un dispositif de réglage du point de fonctionnement d'un circuit électronique comportant plusieurs éléments dont chacun présente un paramètre variable en fonction d'un signal électrique de commande.

Elle s'applique aux circuits électroniques analogiques comportant plusieurs éléments réglables pour chacun desquels le paramètre est ajustable sur une large gamme. Un tel circuit est par exemple un système d'accord en fréquence comprenant un filtre et un oscillateur local accordables tous deux par l'intermédiaire d'une diode à capacité variable ou «diode varicap», ou un atténuateur à diode à résistance variable haute fréquence ou «diode PIN». A cet égard l'application préférée de l'invention est la sélection des canaux dans un récepteur de télévision, notamment du type captant des émissions provenant d'un satellite.

La commande des différents éléments réglables est jusqu'à présent assurée par un même signal de commande ou encore par différents signaux à partir de réseaux potentiométriques ou encore de réseaux actifs linéaires.

La relation liant les valeurs des différents éléments réglables ne restant pas toujours la même dans toute la plage de fonctionnement de ce circuit cette commande connue présente certains inconvénients néfastes au fonctionnement optimum du circuit électronique.

Dans le cas d'un filtre accordable à l'aide de plusieurs diodes varicap, ce filtre doit présenter un gabarit assez large, car il est impossible de garantir un accord parfait sur toute la bande de fonctionnement. Dans le cas de l'atténuateur à diodes PIN, l'impédance d'entrée ne reste pas constante dans toute la gamme d'atténuation.

Par ailleurs ces circuits à plusieurs éléments variables commandés selon la technique antérieure présentent l'inconvénient de nécessiter un réglage, dans la plupart des cas manuels, pour chaque produit fabriqué et ceci à cause de la dispersion des caractéristiques des éléments employés.

Dans le brevet allemand DE-A-2 834 231 est décrit un récepteur superhétérodyne comportant un oscillateur local et un circuit d'entrée. Des diodes varicap permettent de régler les caractéristiques de l'oscillateur et du circuit d'entrée. La tension de commande de la diode est fournie par un convertisseur numérique/analogique sur l'entrée duquel est appliqué un mot de n bits provenant de la sortie d'une mémoire. Ce mot de n bits ou une partie des bits de ce mot est aussi appliqué sur une entrée d'adresse d'une mémoire ROM qui délivre sur sa sortie de données un signal numérique commandant, par l'intermédiaire d'un convertisseur numérique/analogique, la diode varicap du circuit d'entrée. Le circuit de ce document antérieur comporte aussi un paramètre variable pour le réglage de l'offset d'un convertisseur.

Le dispositif de réglage du point de fonctionnement d'un circuit électronique comportant plusieurs éléments variables qui est réalisé selon l'invention présente une mémoire de très faible capacité et ne comporte pas d'élément à réglage manuel.

Le dispositif selon l'invention est destiné au réglage du point de fonctionnement d'un circuit électronique à oscillateur local et à dispositif de sélectivité constitué par un filtre accordable à l'aide de diodes varicap ou d'un atténuateur à diode PIN; il comporte n éléments dont chacun présente un paramètre variable dont la valeur est déterminée par un signal électrique de commande fourni par des moyens de mémoire faisant partie du dispositif de réglage. Il est caractérisé en ce que, n étant au moins égal à trois, les moyens de mémoire comprennent, d'une part, une mémoire adressable par un unique mot numérique A et contenant des mots numériques $C_2 \ldots C_n$ dont chacun est égal à la différence $B_2-B_1 \ldots B_n-B_1$ entre le mot $B_2 \ldots B_n$ représentant le signal de commande d'un élément et le mot $B_1$ représentant le signal de commande du premier élément, le nombre de bits de chacun de ces mots de différence $C_2 \ldots C_n$ étant inférieur au nombre de bits du mot correspondant $B_2 \ldots B_n$ et, d'autre part $n-1$ additionneurs pour effectuer les sommes $C_2 + B_1 \ldots C_n + B_1$ de chacun des mots numériques de différence $C_2 \ldots C_n$ et du mot $B_1$ représentant le signal de commande du premier élément.

Avec cette disposition la capacité de la mémoire utilisée peut être très faible, plus faible que celle qui résulterait de l'utilisation de la technique décrite dans le brevet US-A-4 152 654. En effet ce brevet US décrit un dispositif de sélection de canaux de télévision qui, dans le but de réduire la capacité de mémoire nécessaire, utilise un unique mot d'adressage numérique auquel sont successivement ajoutés des incréments mémorisés qui représentent les différences entre les mots de commande des canaux successifs. Un tel dispositif présente l'inconvénient de nécessiter la mise en mémoire intermédiaire des mots de commande successifs engendrés. En outre l'application du principe utilisé dans ce document au problème visé par la présente demande nécessiterait l'enregistrement des mots successifs engendrés afin de pouvoir les appliquer simultanément, ce qui entraînerait une complication excessive du dispositif et la perte d'au moins une partie importante du gain de mémoire réalisé.

D'autres caractéristiques et avantages de l'invention ressortiront de la description suivante donnée à titre d'exemple non limitatif et illustrée par les figures annexées qui représentent:

— la figure 1, un schéma simplifié d'un dispositif selon l'invention,

— la figure 2, un schéma d'une réalisation du dispositif selon l'invention, et

— les figures 3 et 4, deux applications du dispositif selon l'invention.

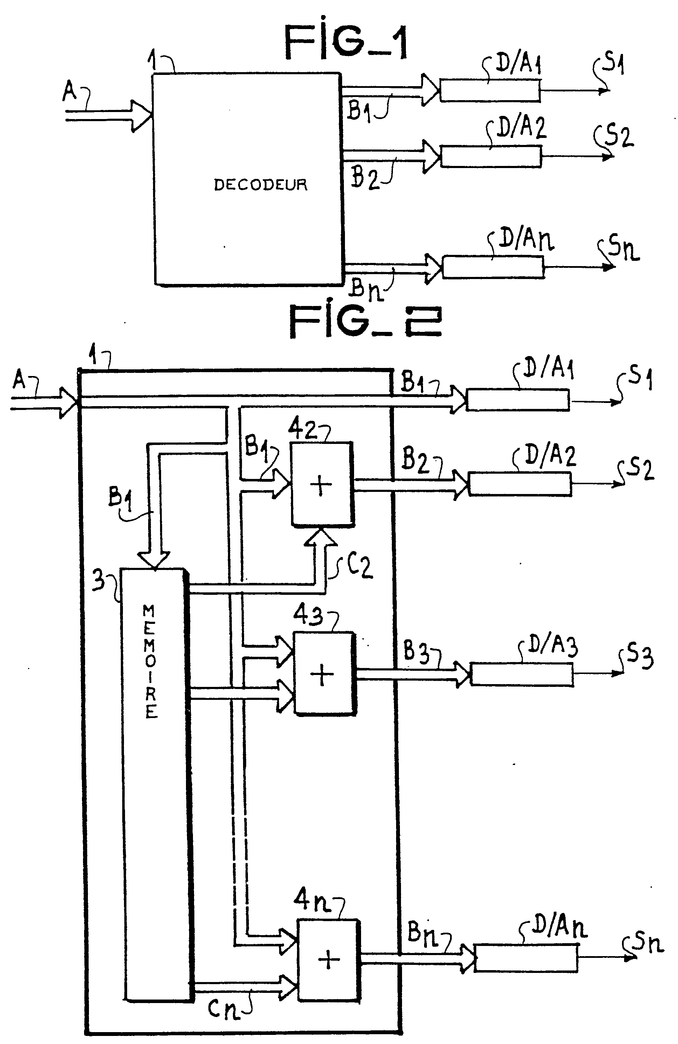

Sur la figure 1, un mot numérique A représentatif du point de fonctionnement choisi, par exemple la fréquence centrale pour un filtre associé à un oscillateur, est injecté en entrée d'un circuit décodeur 1 dont les sorties fournissent, à partir de ce mot A, n mots numériques $B_1$, $B_2$, ..., $B_n$. Le n mots numériques sont injectés en entrée de n convertisseurs numérique/analogique $D/A_1$, $D/A_2$, ..., $D/A_n$. Le mot numérique $B_1$ est transformé en signal analogique $S_1$ de commande dont la valeur est liée à la valeur de ce mot numérique. De la même manière, les mots numériques $B_2$, ... $B_n$ sont transformés en signaux analogiques $S_2$, ... $S_n$.

Les n signaux analogiques $S_1$, $S_2$, ..., $S_n$ ainsi obtenus permettent de commander n éléments variables d'un circuit à plusieurs éléments variables.

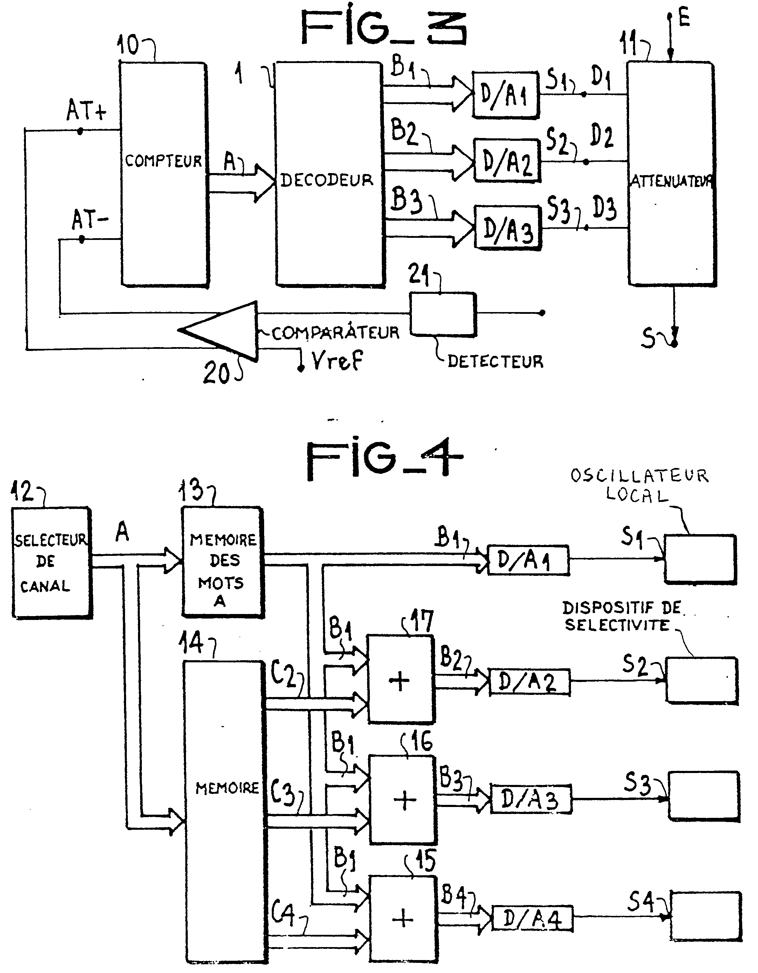

Le circuit décodeur 1 (figure 2) comporte un circuit mémoire 3 et n−1 additionneurs $4_2$, $4_3$ ... $4_n$.

La première sortie $B_1$ est directement reliée à l'entrée A. Le mot numérique $B_1$ est donc identique au mot numérique A représentatif d'un point de fonctionnement choisi.

On mémorise dans la mémoire 3 les différences $C_2$, ..., $C_n$ entre les mots numériques $B_2$, ..., $B_n$ et le mot $B_1$, c'est-à-dire: $C_2 = B_2 - B_1$; $C_3 = B_3 - B_1$ ... $C_n = B_n - B_1$. En effet, dans un dispositif ayant plusieurs éléments variables, les tensions ou courants de commande de ces éléments suivent la même tendance, les différences entre l'un des signaux analogiques de commande et les autres étant faibles et variant lentement. De ce fait les mots numériques $C_2$, ..., $C_n$ représentant les différences entre $B_2$, ..., $B_n$ d'une part et $B_1$ d'autre part, ont un nombre de bits (éléments binaires) très inférieur au nombre de bits de $B_2$, ..., $B_n$. La capacité de la mémoire 3 est donc inférieure à la capacité d'une mémoire qui stockerait les mots $B_2$, ... $B_n$. La lenteur de variation permet d'utiliser la même différence pour plusieurs valeurs consécutives du mot numérique A, ce qui peut être réalisé simplement en n'utilisant qu'une partie des bits du mot numérique $B_1$, identique au mot A, pour adresser la mémoire 3. Ce nombre de bits peut être déterminé selon l'application. Ceci contribue donc à diminuer considérablement la taille de la mémoire.

Le mot numérique A, identique à $B_1$, est appliqué en entrée d'adressage de la mémoire 3, cette dernière pouvant comporter n−1 mémoires, contenant chacune un mot, et à une entrée des additionneurs $4_2$ ... $4_n$. La sortie $C_2$ de la mémoire 3 est reliée à une seconde entrée de l'additionneur $4_2$, la sortie $C_3$ de la mémoire à une seconde entrée de l'additionneur $4_s$ ... et la sortie $C_n$ à une seconde entrée de l'additionneur $4_n$.

Le mot numérique $C_2$ étant la différence entre le mot numérique $B_2$ désiré et le mot numérique $B_1$, en faisant, à l'aide de l'additionneur $4_2$, $B_1 + C_2$ on retrouve $B_2$ en sortie.

Dans le cas où seulement une partie des bits du mot numérique $B_1$ sert de mot d'adressage de la mémoire 3 où sont enregistrés les mots $C_2$, $C_3$, ..., $C_n$, seules les lignes de transmission des bits utiles sont reliées à l'entrée d'adresse. Ces bits utiles sont de préférence les bits les plus significatifs.

En effet, le mot numérique A est transmis en parallèle c'est-à-dire que chaque bit du mot est transmis par un conducteur différent. Il suffit donc de prendre les conducteurs transférant les bits intéressant pour l'adressage de la mémoire 3 et de les connecter en entrée d'adressage.

La mémoire 3 peut être du type PROM, c'est-à-dire une mémoire morte programmable, la programmation se faisant au niveau de la fabrication du dispositif selon l'invention en fonction des caractéristiques des éléments variables.

Le schéma de la figure 2 peut s'appliquer dans le cas de la télévision, à un dispositif d'accord par synthèse de tension. Dans ce cas, la fréquence d'un oscillateur local et la fréquence centrale de plusieurs dispositifs de sélectivité sont commandées par des tensions de commande.

Dans le cas de la modulation d'amplitude la fréquence de l'oscillateur local doit être de grande précision. Cette fréquence est donc directement commandée par le mot numérique $B_1$ identique au mot A et est convertie en tension par le convertisseur numérique/analogique $D/A_1$.

Dans un exemple on prévoit 8 canaux différents, chaque canal correspondant à une fréquence d'accord du dispositif d'accord par synthèse de tension. Ces 8 canaux sont représentés par 8 valeurs différentes du mot numérique A. Ces 8 valeurs peuvent être stockées dans une mémoire du type EAROM ou mémoire morte effaçable et reprogrammable électriquement. Le mot numérique A a par exemple une longueur de 12 bits.

La tension de commande $S_1$ de l'oscillateur local est obtenue par un convertisseur numérique/analogique $D/A_1$, qui reçoit en entrée le mot numérique $B_1$ identique à A.

Dans la mémoire 3, sont stockées les différences entre les mots numériques $B_2$, $B_3$, ..., $B_n$ qui, après conversion numérique/analogique, fournissent les tensions de commande des dispositifs de sélectivité, et le mot $B_1$.

La figure 3 représente un dispositif selon l'invention appliqué à la commande d'un circuit atténuateur à diodes PIN.

Un circuit décodeur 1 idendique à celui de la figure 2 fournit sur des sorties des mots numériques $B_1$, $B_2$, $B_3$ qui sont convertis par des convertisseurs numérique/analogique $D/A_1$, $D/A_2$, $D/A_3$. Les signaux analogiques résultants $S_1$, $S_2$, et $S_3$ permettent de commander l'atténuateur à diodes PIN 11, le signal $S_1$ étant injecté en entrée $D_1$ de l'atténuateur 11, le signal $S_2$ en entrée $D_2$ et le signal $S_3$ en entrée $D_3$. Chaque signal commande une des trois diodes PIN de l'atténuateur 11.

Le mot numérique unique A est fourni par un compteur numérique 10. A l'aide de deux entrées $AT^+$ et $AT^-$, il est possible d'augmenter ou de diminuer la valeur représentant l'état du compteur 10, et donc d'augmenter ou diminuer la valeur du mot numérique A et, ainsi, de changer les valeurs des mots $B_1$, $B_2$, et $B_3$ et donc les valeurs des signaux de commandes $S_1$, $S_2$ et $S_3$.

Dans un système de contrôle automatique de gain, les entrées $AT^+$ et $AT^-$ du compteur 10 sont connectées aux sorties d'un comparateur 20 comparant un signal contrôlé en niveau correspondant au signal sur la sorite S de l'atténuateur 11 à un signal de référence. Dans l'exemple le signal contrôlé en niveau est redressé par un détecteur 21 avant d'être appliqué à l'entrée du comparateur 20.

La figure 4 représente un dispositif selon l'invention appliqué à la réception directe d'émissions de télévision provenant d'un satellite.

Dans cet exemple, les signaux reçus sont en modulation de fréquence et il est possible de recevoir 40 canaux différents.

La précision requise pour la fréquence de l'oscillateur local en modulation de fréquence est inférieure à celle requise en modulation d'amplitude.

On stocke donc dans une mémoire 13 les 40 valeurs du mot numérique A, chacune de ces valeurs représentant un canal. Cette mémoire 13 peut être du type PROM, c'est-à-dire mémoire morte programmable.

Le mot numérique $B_1$ après conversion numérique/analogique permet de commander la fréquence de l'oscillateur local, cet oscillateur étant utilisé avec trois dispositifs de sélectivité commandés après conversion numérique/analogique par les mots numériques $B_2$, $B_3$, et $B_4$.

En effet, les mots numériques $C_2$, $C_3$, et $C_4$, correspondant aux différences entre $B_2$, $B_3$, $B_4$ et le mot numérique $B_1$, sont stockés dans une mémoire 14.

Les valeurs de ces mots numériques de différence $C_2$, $C_3$ et $C_4$ correspondent aux valeurs des signaux analogiques $S_2$, $S_3$ et $S_4$ appropriés à l'accord des dispositifs de sélectivité pour chacun des 40 canaux.

Les mots d'adressage A des mémoires 13 et 14 sont fournis par un sélecteur de canal 12. Ce sélecteur 12 stocke 40 valeurs de mots numériques A, chaque valeur correspondant à un canal.

A un canal donné, et donc une valeur donnée $A_1$ du mot numérique A d'adresse, correspond d'une part une valeur du mot numérique $B_1$ dans la mémoire 13, et d'autre part une valeur du mot numérique $C_2$, une valeur du mot numérique $C_3$ et une valeur du mot numérique $C_4$ ($C_2$ étant égal à $B_2-B_1$, $C_3$ à $B_3-B_1$, et $C_4$ à $B_4-B_1$).

Le mot numérique $B_1$ est converti, à l'aide du convertisseur numérique/analogique $D/A_1$, en un signal analogique de commande de la fréquence de l'oscillateur local à une valeur correspondant au canal choisi. Un additionneur 17 reçoit sur ses entrées le mot $B_1$ et le mot $C_2 = B_2-B_1$. Il fournit donc le mot numérique $B_2$ en sortie; ce mot est converti à l'aide du convertisseur numérique/analogique $D/A_2$ en un signal $S_2$ de commande de sélectivité à une valeur correspondant au canal choisi. L'additionneur 16 fournit le mot numérique $B_3$ converti en signal analogique $S_3$ et l'additionneur 15 le mot numérique $B_4$ converti en signal analogique $S_4$.

Les fréquences des différents canaux étant définies par une planification internationale, il est possible de programmer les mémoires au moment de la fabrication, en fonction des caractéristiques propres des éléments variables. Ceci élimine donc toute intervention de la part de l'utilisateur ou de l'installateur.

Le dispositif selon l'invention permet donc d'obtenir des signaux de commande indépendants pour chacun des éléments variables d'un système analogique à large plage de fonctionnement. Il est particulièrement adapté à la réalisation d'un filtre accordable en réception d'émissions de télévision provenant d'un satellite.

**Revendications**

1. Dispositif de réglage du point de fonctionnement soit d'un circuit électronique à oscillateur local et à dispositif de sélectivité constitué par un filtre accordables à l'aide de diodes «varicap» soit d'un circuit atténuateur à diodes «PIN», ce circuit comportant n éléments dont chacun présente un paramètre variable dont la valeur est déterminée par un signal électrique de commande fourni par des moyens de mémoire faisant partie du dispositif de réglage, caractérisé en ce que, n étant au moins égal à trois, les moyens de mémoire comprennent, d'une part, une mémoire (3; 14) adressable par un unique mot numérique (A) et contenant des mots numériques ($C_2 \ldots C_n$) dont chacun est égal à la différence ($B_2-B_1 \ldots B_n-B_1$) entre le mot ($B_2 \ldots B_n$) représentant le signal de commande d'un élément et le mot ($B_1$) représentant le signal de commande du premier élément, le nombre de bits de chacun de ces mots de différence ($C_2 \ldots C_n$) étant inférieur au nombre de bits du mot correspondant ($B_2 \ldots B_n$), et, d'autre part, n−1 additionneurs ($4_2$, $4_3 \ldots 4_n$; 15, 16, 17) pour effectuer les sommes ($C_2+B_1 \ldots C_n+B_1$) de chacun des mots numériques de différence ($C_2 \ldots C_n$) et du mot ($B_1$) représentant le signal de commande du premier élément.

2. Dispositif selon la revendication 1, caractérisé en ce que plusieurs valeurs consécutives de l'unique mot numérique (A) d'adressage de la mémoire (3; 14) entraînent des mêmes valeurs des mots numériques de commande des éléments.

3. Dispositif selon la revendication 1 ou 2, caractérisé en ce que le mot utilisé pour l'adressage de la mémoire (3) ne comporte qu'une partie des bits du mot numérique de commande du premier élément.

4. Dispositif selon l'une quelconque des revendications 1 à 3, caractérisé en ce que le mot numérique représentant le signal de commande du premier élément est identique au mot numérique (A) d'adressage.

5. Dispositif selon l'une quelconque des revendications précédentes, caractérisé en ce que la mémoire est une mémoire morte du type programmable (PROM).

6. Dispositif selon la revendication 1, caractérisé en ce que le mot d'adressage (A) est appliqué à l'entrée d'une mémoire supplémentaire (13) sur la sortie de laquelle apparaît le mot de commande ($B_1$) du premier élément.

7. Dispositif selon l'une quelconque des revendications précédentes, caractérisé en ce que le mot numérique d'adressage (A) est fourni par un compteur (10).

8. Dispositif selon la revendication 7, caractérisé en ce que lesdits éléments étant des diodes PIN faisant partie d'un atténuateur (11) les entrées de comptage et décomptage (AT+ et AT−) du compteur (10) sont connectées aux sorties d'un comparateur comparant le signal de sortie de l'atténuateur (11) à un signal de référence.

9. Dispositif selon l'une quelconque des revendications 1 à 6, caractérisé en ce que le générateur du mot numérique d'adressage (A) est un sélecteur de canal contenant en mémoire un nombre de mots égal au nombre des canaux d'un récepteur de télévision, notamment du type destiné à recevoir des émissions provenant d'un satellite.

10. Dispositif selon les revendications 4 et 9, caractérisé en ce que le premier mot numérique $(B_1)$ commande, en modulation d'amplitude, la fréquence de l'oscillateur local et en ce que les autres mots numériques $(B_2 \ldots B_n)$ commandent les fréquences centrales de dispositifs de sélectivité respectifs.

## Claims

1. A device for adjusting the working point either of an electronic circuit including a local oscillator and a selectivity device constituted of a filter, tunable by means of «varipac»-diodes, or of an attenuator circuit using «PIN»-diodes, this circuit comprising n elements, each presenting a variable parameter whose value is determined by an electric control signal issued by memory means forming part of the control device, characterized in that, n being at least equal to three, the storage means include, on the on hand, a memory unit (3; 14) which is addressable by means of a single digital word (A) and contains digital words $(C_2 \ldots C_n)$, each being equal to the difference $(B_2-B_1 \ldots B_n-B_1)$ existing between the word $(B_2 \ldots B_n)$ that represents the control signal of an element $(B_1)$ that represents the control signal of the first element, the number of bits of each of these difference words $(C_2 \ldots C_n)$ being smaller than the number of bits of the corresponding word $(B_2 \ldots B_n)$, and, on the other hand, n−1 adders $(4_2, 4_3 \ldots 4_n; 15, 16, 17)$ for producing the sums $(C_2+B_1 \ldots C_n+B_1)$ of each digital difference word $(C_2 \ldots C_n)$ and the word $(B_1)$ that represents the control signal of the first element.

2. A device according to claim 1, characterized in that a plurality of consecutive values of the single digital word (A) for addressing the memory (3; 14) entrains the same values of the digital control words of the elements.

3. A device according to claim 1 or 2, characterized in that the word used for addressing the memory (3) comprises only some of the bits of the digital control word of the first element.

4. A device according to anyone of claims 1 to 3, characterized in that the digital word representing the control signal of the first element is identical with the digital addressing word (A).

5. A device according to anyone of the preceding claims, characterized in that the memory is a programmable read only memory (PROM).

6. A device according to claim 1, characterized in that the addressing word (A) is applied to the input of a supplementary memory (13), at the output of which appears the control word $(B_1)$ of the first element.

7. A device according to anyone of the preceding claims, characterized in that the digital addressing word (A) is supplied by a counter (10).

8. A device according to claim 7, characterized in that, said elements being PIN-diodes that form part of the attenuator unit (11), the up and down counting inputs (AT+, AT−) of the counter (10) are connected to the outputs of a comparator adapted to compare the output signal of the attenuator unit (11) with a reference signal.

9. A device according to anyone of the claims 1 to 6, characterized in that the generator for generating the digital addressing word (A) is a channel selector having stored a number of words equal to the number of channels of a television receiver, notably of the type intended to receive satellite transmissions.

10. A device according to claims 4 and 9, characterized in that the first digital control word $(B_1)$ controls by amplitude modulation the frequency of the local oscillator, and that the other digital words $(B_2 \ldots B_n)$ control the central frequencies of the respective devices.

## Patentansprüche

1. Einrichtung zur Regelung des Arbeitspunktes entweder einer elektronischen Schaltung mit lokalem Oszillator und einer aus einem Filter bestehenden Selektivitätsvorrichtung, die mit Hilfe von «Varicap»-Dioden abstimmbar sind, oder einer Dämpfungsschaltung mit PIN-Dioden, wobei diese Schaltung n Elemente aufweist, die je einen variablen Parameter besitzen, dessen Wert durch ein elektrisches Steuersignal bestimmt wird, das von zu der Regeleinrichtung gehörenden Speichermitteln geliefert wird, dadurch gekennzeichnet, daß n mindestens gleich drei ist und die Speichermittel einerseits einen durch ein einziges Digitalwort (A) adressierbaren und Digitalwörter $(C_2 \ldots C_n)$ enthaltenden Speicher (3; 14), wobei jedes dieser letztgenannten Digitalwörter $(C_2 \ldots C_n)$ gleich der Differenz $(B_2-B_1 \ldots B_n-B_1)$ zwischen dem das Steuersignal eines Elementes darstellenden Wort $(B_2 \ldots B_n)$ und dem das Steuersignal des ersten Elementes darstellenden Wort $(B_1)$ ist und die Anzahl der Bits jedes dieser Differenzwörter $(C_2 \ldots C_n)$ kleiner als die Anzahl der Bits des entsprechenden Wortes $(B_2 \ldots B_n)$ ist, und andererseits n−1 Addierer $(4_2, 4_3 \ldots 4_n; 15, 16, 17)$ zur Summenbildung $(C_2+B_1 \ldots C_n+B_1)$ jedes digitalen Differenzwortes $(C_2 \ldots C_n)$ und des das Steuersignal des ersten Elementes darstellenden Wortes $(B_1)$ aufweisen.

2. Einrichtung nach Anspruch 1, dadurch gekennzeichnet, daß mehrere aufeinanderfolgende Werte des einzigen Digitalwortes (A) zur Adressierung des Speichers (3; 14) gleiche Werte der digitalen Steuerworte nach sich ziehen.

3. Einrichtung nach Anspruch 1 oder 2, dadurch gekennzeichnet, daß das zur Adressierung des Speichers (3) benutzte Wort nur einen Teil des digitalen Steuerwortes des ersten Elementes aufweist.

4. Einrichtung nach einem beliebigen der Ansprüche 1 bis 3, dadurch gekennzeichnet, daß das das Steuersignal des ersten Elementes darstellende Digitalwort mit dem digitalen Adressierwort (A) identisch ist.

5. Einrichtung nach einem der vorhergehenden Ansprüche, dadurch gekennzeichnet, daß der Speicher ein programmierbarer Festspeicher (PROM) ist.

6. Einrichtung nach Anspruch 1, dadurch gekennzeichnet, daß das Adressierwort (A) an den Eingang eines Zusatzspeichers (13) gelegt wird, an dessen Ausgang das Steuerwort $(B_1)$ des ersten Elementes erscheint.

7. Einrichtung nach einem beliebigen der vorhergehenden Ansprüche, dadurch gekennzeichnet, daß das digitale Adressierwort (A) von einem Zähler (10) geliefert wird.

8. Einrichtung nach Anspruch 7, dadurch gekennzeichnet, daß die Elemente PIN-Dioden sind, die zu einer Dämpfungsschaltung (11) gehören, und daß die Eingänge des Zählers (10) zum Vorwärts- und Rückwärtszählen (AT+ und AT−) mit den Ausgängen eines Komparators verbunden sind, der das Ausgangssignal der Dämpfungsschaltung (11) mit einem Bezugssignal vergleicht.

9. Einrichtung nach einem beliebigen der Ansprüche 1 bis 6, dadurch gekennzeichnet, daß der Generator zur Erzeugung des digitalen Adressierwortes (A) aus einem Kanalwähler besteht, der im Speicher eine Anzahl von Wörtern hält, die der Anzahl der Kanäle eines vorzugsweise zum Empfang von von einem Satelliten kommenden Sendungen bestimmten Fernsehempfängers gleicht.

10. Einrichtung nach einem der Ansprüche 4 und 9, dadurch gekennzeichnet, daß das erste Digitalwort $(B_1)$ über Amplitudenmodulation die Frequenz des lokalen Oszillators steuert, und daß die anderen Digitalwärter $(B_2 \ldots B_n)$ die Mittelfrequenzen der jeweiligen Selektivitätsvorrichtungen steuern.

# FIG_1

# FIG_2

# FIG_3

# FIG_4